# NEW EUROPEAN PATENT SPECIFICATION

(11) **EP 0 497 350 B2**
(45) Date of publication and mention of the opposition decision: **09.01.2002**
(45) Mention of the grant of the patent: 02.08.1995
(21) Application number: 92101560.8
(22) Date of filing: 30.01.1992
(51) Int. Cl.: C30B 25/02, H01L 21/20

(54) **Crystal growth method for gallium nitride-based compound semiconductor**
Kristallzuchtverfahren für Halbleiter auf Galliumnitrid-Basis
Méthode de croissance cristalline pour un composé semiconducteur à base de nitrure de gallium

(30) Priority: 31.01.1991 JP 3225991; 27.03.1991 JP 8984091
(43) Date of publication of application: 05.08.1992
(73) Proprietor: Nichia Kagaku Kogyo K.K., Anan-shi Tokushima-ken (JP)
(72) Inventor: Nakamura, Shuji, c/o Nichia Kagaku Kogyo K.K., Anan-shi, Tokushima-ken (JP)
(74) Representative: von Bezold, Dieter, Dr.

(56) References cited:
- EP-B1- 0 115 204
- DE-A- 3 802 732
- DE-A- 4 006 449
- JP-A- 5 223 600
- Appl. Phys. Lett., vol. 48, no. 5, 03.02.1986, American Institute of Physics, US; H. AMANO, N. SAWAKI, I. AKASAKI: "Metalorganic vapor phase epitaxial growth of a high quality GaN film using an AlN buffer layer", pp. 353 - 355
- Patent Abstracts of Japan, vol. 015, No. 003 (E-1019) 7 January 1991
- Extended Abstracts, vol. 87-2, 18 October 1987, Princeton, New Jersey, US, pages 1602-1603; Nagatomo: 'epitaxial growth of GaN films by low pressure metalorganic chemical vapor phase deposition'
- Patent Abstracts of Japan, vol. 014, no. 263 (E-0938) 7 June 1990
- W. Seifert, A. Tempel, Physica Status Solidi (A) 23, K 39(1974)
- K. Naniwae et al., J. of Crystal Growth 99 (1990), 381 - 384
- I. Akasaki et al., J. of Crystal Growth 98 (1989), 209-219
- H. Amano et al., Japan. J. Appl. Phys., vol. 28, pp. L 2112 - L2114, Dec. 1989
- H. Amano et al., J. Lumin, vols. 40 and 41, pp. 121 -122, 1988
- M. llegems et al., J. Appl.Phys., vol. 43, No. 9, September 1972, pp. 3797 - 3800
- G.B. Stringfellow: "Organometallic Vapor-Phase Epitaxy: Theory and Practice", Academic Press Inc., San Diego, US, 1989, p. 24 - 27, 48, 49
- Y. Koide et al., Japanese Journal of Appl.Physics, vol. 27, no. 7, July 1988, pp. 1156-1161
- Y. Koide et al., J. Electrochem.Society, vol. 133, no. 9, September 1986, pp. 1956-1960
- G.B. Stringfellow: "Organometallic Vapor-Phase Epitaxy: Theory and Practice", Academic Press Inc., San Diego, US, 1989, p. 2-3

## Description

The present invention relates to a method of growing crystals of a gallium nitride-based compound semiconductor on a substrate consisting of, e.g., sapphire and, more particularly, to a method of growing an epitaxial layer of a gallium nitride-based compound semiconductor with a high crystallinity.

Recently, a blue light-emitting device using a gallium aluminium nitride-based compound semiconductor, e.g., a compound represented by the formula Ga_{X}Aℓ_{1-X}N (0 ≦ X ≦ 1) has attracted attention.

As a method of growing crystals of such a gallium nitride-based compound semiconductor, a metalorganic chemical vapor deposition method (to be referred to as an MOCVD method hereinafter) is well known. In this method, an organometallic compound gas is supplied as a reaction gas into a reactor in which a sapphire substrate is placed, and the surface temperature of the substrate is held at a high temperature of 900°C to 1,100°C, thereby growing an epitaxial layer of compound semiconductor on the substrate. For example, when a GaN epitaxial layer is to be grown, trimethylgallium gas and ammonia gas are used as a Ga-containing gas and an N-containing gas, respectively.

In order to use the grown expitaxial layer of a gallium nitride-based compound semiconductor as a light-emitting device, it is essential to improve the crystallinity of the layer first.

On the surface of the expitaxial layer of GaAIN, formed directly on the sapphire substrate using the MOCVD method, numerous projections and recesses are produced in the form of a hexagonal pyramid-like or hexagonal pillar-like growth pattern. For this reason, crystal surface morphology is very poor in the obtained crystal. Therefore, it is almost impossible to fabricate a blue light-emitting device using a semiconductor crystal layer having numerous projections and recesses on its surface and a very poor surface morphology because the yield is very low.

In order to solve the above problems, each of Appl. Phys. Lett. 48, (1986), page 353 and Published Unexamined Japanese Patent Application No. 2-229476, for example, proposes a method of growing an AIN buffer layer on a substrate before growth of an expitaxial layer of a gallium nitride-based compound semiconductor. In this method, an AIN buffer layer with a film thickness of 100 to 500Å is formed on a sapphire substrate at a relatively low growth temperature of 400 °C to 900 °C. According to this method, the crystallinity and the surface morphology of a GaAIN expitaxial layer can be improved to some extent by growing the GaAIN expitaxial layer on the AIN layer as a buffer layer.

Equally DE-OS 40 06 449 discloses the vapor deposition of an AlₓGa₁₋ₓN layer onto an AIN buffer layer. The buffer layer is formed at a growth temperature of between 380 and 800°C and has a thickness of 10.0 - 50.0 nm.

In this method, however, it is necessary to strictly restrict the growth conditions of the buffer layer. In particular, the film thickness must be strictly set at a very small value of 100 to 500Å. In addition, it is difficult to uniformly form the buffer layer with a predetermined film thickness on the entire surface of large-area sapphire substrate, e.g., a sapphire substrate about 50 mm in diameter. Therefore, it is difficult to improve the crystallinity and the surface morphology of a GaAℓN epitaxial layer formed on the buffer layer with a high yield. Furthermore, the obtained crystallinity is still unsatisfactory to form a practical light-emitting diode or semiconductor laser, i.e., it requires further improvements.

In addition, this method cannot realize a p-n junction sufficient to put a light-emitting diode or the like into practical use. In general, when a light-emitting device is to be fabricated by forming a compound semiconductor layer on a substrate, doping a small amount of an impurity in the compound semiconductor to form an n- or p-type layer and in this manner obtain a p-n junction is known as a very effective means of improving the luminance of the device. However, no blue light-emitting device which realizes a sufficient luminance has been developed yet. The reason for this is that p conductivity type of a semiconductor crystal film cannot be formed.

It is difficult for conventional methods to form a p-type semiconductor crystal film even if p-type impurities such as Zn and Mg may be doped in a GaAℓN epitaxial layer, because the crystal film has extremely bad crystallinity. For this reason, conventionally, n-type GaN is grown on a sapphire substrate by, e.g., Halide Vapor Phase Epitaxial (HVPE) crystal growth method, Zn diffusion is Performed for the grown layer, and an I layer is formed to fabricate a blue light-emitting device with an MIS structure. However, a light-emitting device fabricated by this method cannot realize a satisfactory luminance efficiency.

In a recently reported technique, in order to form p conductivity type of a semiconductor crystal film, Mg is doped in GaN epitaxial layer, and then an electron beam is radiated on the GaN layer (Oyo Butsuri, 1991, Vol. 60, February, pp. 163 to 166). In this technique, the MOCVD method is used to form an AℓN buffer layer with a thickness of 0.02 to 0.05 µm on a sapphire substrate at a low temperature (about 400 °C to 600°C). Subsequently, the temperature is increased to 1,000°C. An Mg-doped GaN layer is then grown on the AℓN buffer layer, and an electron beam is radiated on the surface to form a p-type Mg-doped GaN layer.

This method, however, is still far from a practical level. That is, the characteristics of the disclosed p-type GaN layer are only a maximum free hole concentration (carrier concentration) of 10¹⁷/cm³ and a minimum resistivity of 12 Ω·cm.

The present invention has been made in consideration of the above situation and has as its object to provide a method which can grow a gallium nitride-based compound semiconductor having crystallinity and surface morphology at practical levels, with high stability and high yield while using a buffer layer.

It is another object of the present invention to provide a method which can grow a p- or n-type semiconductor layer at an excellent practical level so as to allow formation of an excellent p-n junction in a GaAℓN for use in a light-emitting device.

According to the present invention this object is achieved with a method according to Claim 1.

Further preferred embodiments of the invention are claimed in the dependent claims 2 to 16.

According to the present invention, a buffer layer and/or a gallium nitride-based compound semiconductor layer can be doped with an n- or p-type impurity on a substrate on the obtained buffer layer.

This invention can be more fully understood from the following detailed description when taken in conjunction with the accompanying drawings, in which:
Fig. 1 is a schematic sectional view showing the structure of an epitaxial wafer according to the crystal growth method of the present invention;
Fig. 2 is a schematic sectional view showing the structure of an epitaxial wafer according to a conventional crystal growth method;
Fig. 3 is a graph showing the relationship between the full width at half-maximum (FWHM) of the double-crystal rocking curve of a GaN epitaxial layer and the film thickness of a buffer layer;
Fig. 4 is a microphotograph showing the structure of crystals of a GaN epitaxial layer;
Fig. 5 is a microphotograph showing the structure of crystals of another GaN epitaxial layer;
Fig. 6 is a microphotograph showing the structure of crystals of still another GaN epitaxial layer;
Fig. 7 is a microphotograph showing the structure of crystals of still another GaN epitaxial layer;
Fig. 8 is a partial schematic sectional view showing an apparatus used in the present invention;
Fig. 9 is a graph showing the two-dimensional distributions of the carrier concentration and the mobility obtained by Hall measurement of GaN crystals according to the present invention;
Fig. 10 is a graph showing the two-dimensional distributions of the carrier concentration and the mobility obtained by Hall measurement of conventional GaN crystals;
Fig. 11 is a sectional view showing the structure of an embodiment of an element using a semiconductor crystal film according to the present invention; and
Fig. 12 is a sectional view showing the structure of another embodiment of the element.

The present invention will be described below.

The surface layer preferably consists of a gallium nitride-based compound.

The thickness of the buffer layer is preferably 0.001 µm to 0.2 µm. If the thickness is smaller than 0.001 µm or larger than 0.5 µm, the surface morphology of the epitaxial layer gallium nitride-based compound formed on the buffer layer tends to be deteriorated.

The first temperature is adjusted to 400°C to 800°C. If the temperature is lower than 200 °C, it becomes difficult to form the buffer layer. If the temperature is higher than 900 ° C, the buffer layer becomes monocrystalline and therefore no longer performs functions as a buffer layer.

The epitaxial layer of the compound formed on the buffer layer is represented by the formula Ga_{X}A_{1-X}N (note that X falls within the range of 0 ≦ X ≦ 1).

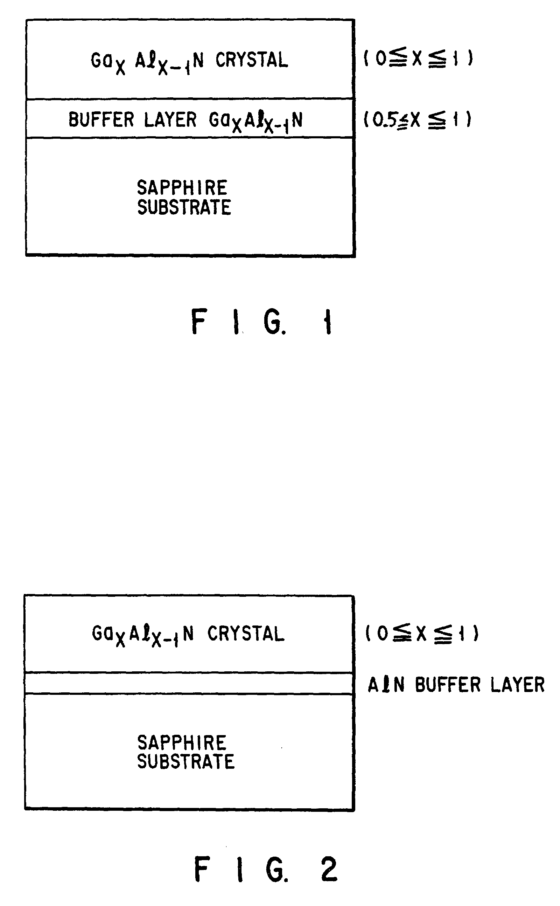

Fig. 1 is a sectional view showing the structure of an epitaxial wafer obtained when a semiconductor layer represented by the formula Ga_{X}Al_{1-X}N (0 ≦ X ≦ 1) are grown on a buffer layer consisting of Ga_{X}Aℓ_{1-X}N (0.5 < X ≦ 1). Fig. 2 is a sectional view showing the structure of wafer obtained when a gallium nitride-based semiconductor layer is grown on an AℓN buffer layer.

The allowable thickness range of the buffer layer of the present invention is wider than those of conventional buffer layers. For this reason, it is possible to grow the buffer layer and the semiconductor layer of the compound represented by the formula Ga_{X}Al_{1-X}N (0 ≦ X ≦ 1) with high yield.

A method of growing a gallium nitride-based compound semiconductor layer using AℓN as a buffer layer is described in detail in, e.g., Thin Solid Films, 163, (1988), page 415, or Appl. Phys. Lett. 48, (1986), page 353. The effects of the buffer layer described in these references will be briefly described below.

AℓN which is grown at a low temperature (about 600°C) is a polycrystalline layer. When the temperature of a substrate on which this AℓN polycrystalline layer is formed is increased to about 1,000°C in order to form, e.g., GaN, this polycrystalline layer partially becomes monocrystalline. The monocrystalline portion serves as a seed crystal with an uniform orientation. When GaN epitaxial layer is grown at 1,000 °C, GaN epitaxial layer is grown from this seed crystal to make it possible to grow an uniform GaN epitaxial layer. If no buffer layer is used, the sapphire substrate itself serves as a seed crystal. Since, in this case every surface portions of the sapphire substrate serve as a seed crystal, there is a large variation in crystal orientations of GaN hexagonal pillars grown on the sapphire substrate.

By comparing the case in which Ga_{X}Aℓ_{1-X}N (0.5 ≦ X ≦ 1) is formed as a buffer layer as in the present invention with the case in which conventional AℓN is used as the buffer layer, the following assumption can be made.

First, suppose that GaN of, e.g., X = 1 is formed as the buffer layer. In this case, the melting point of GaN is 1,100 °C and the melting point of Aℓ N is 1,700 ° C. When a buffer layer of GaN is formed at 600 °C, a polycrystalline layer results. Subsequently, when the temperature of the substrate is increased to 1,000°C in order to grow a GaN epitaxial layer on this polycrystalline GaN layer, the GaN buffer layer partially becomes monocrystalline. As in the case wherein AℓN is used as a buffer layer, this monocrystalline portion serves as a seed crystal for a GaN epitaxial layer.

It is assumed that the following advantages can be obtained by the present invention compared with the case in which the AℓN buffer layer is formed.

First, since the melting point is low, conversion into single-crystals easily occurs during the rise of the temperature. Therefore, the effects as a buffer layer can be expected even when the thickness of the buffer layer is increased.

Secondary, the buffer layer consists of GaN. As a result, an improvement in crystallinity can be expected when the GaN epitaxial layer is grown on the buffer layer because the epitaxial layer is formed on the layer of the same material.

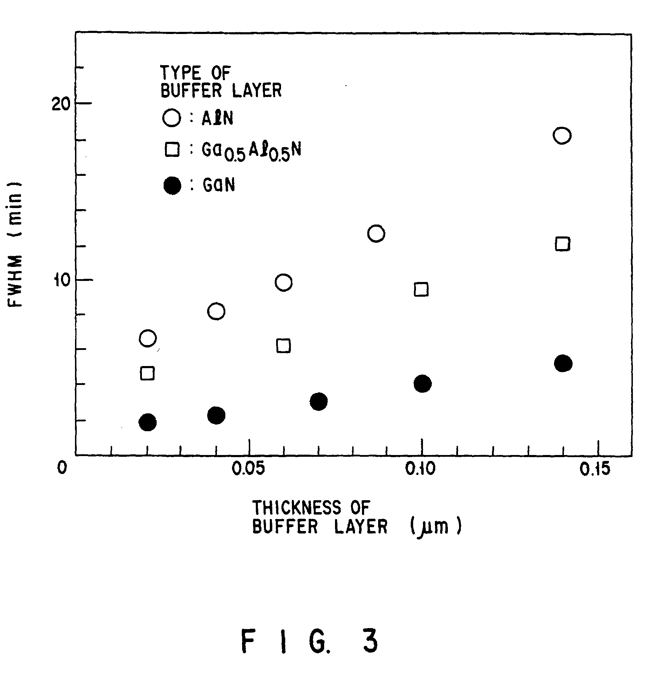

To confirm the above advantages, three types of buffer layers consisting of AℓN, Ga_{0.5}Aℓ_{0.5}N, and GaN were independently formed on sapphire substrates at 600°C, and a 4-µm thick GaN epitaxial layer was grown on each of the formed layers at 1,000°C. A measurement was made for the full width at half-maximum (FWHM) of the double-crystal X-ray rocking curve of each GaN epitaxial layer. Fig. 3 is a graph showing the relationship between the FWHM and the film thickness of the buffer layer. In Fig. 3, the smaller the FWHM is, the better the crystallinity.

As shown in Fig. 3, it was found that when GaN was formed as the buffer layer, a better crystallinity could be obtained over a wide film thickness range of the buffer layer, and that the effect of Ga_{0.5}Aℓ_{0.5}N was intermediate of the three cases. This indicates that the advantages assumed above are correct.

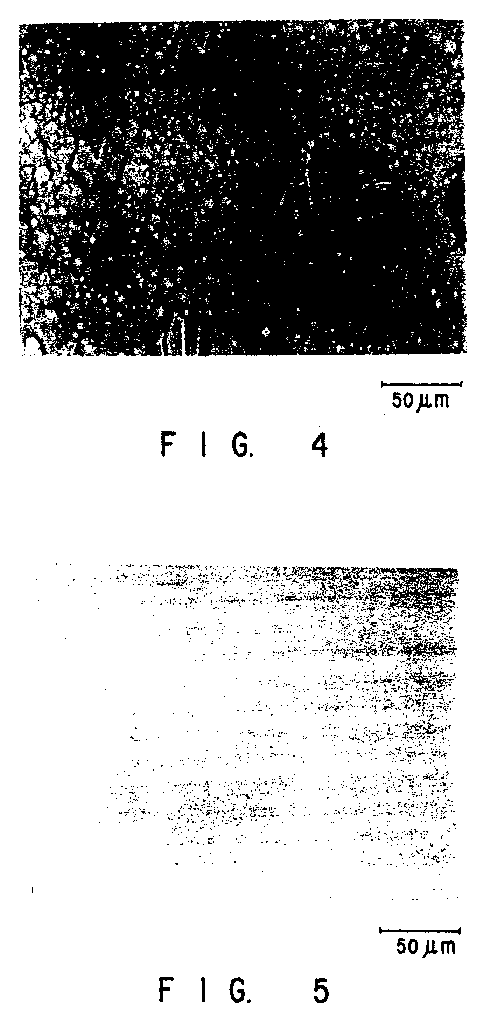

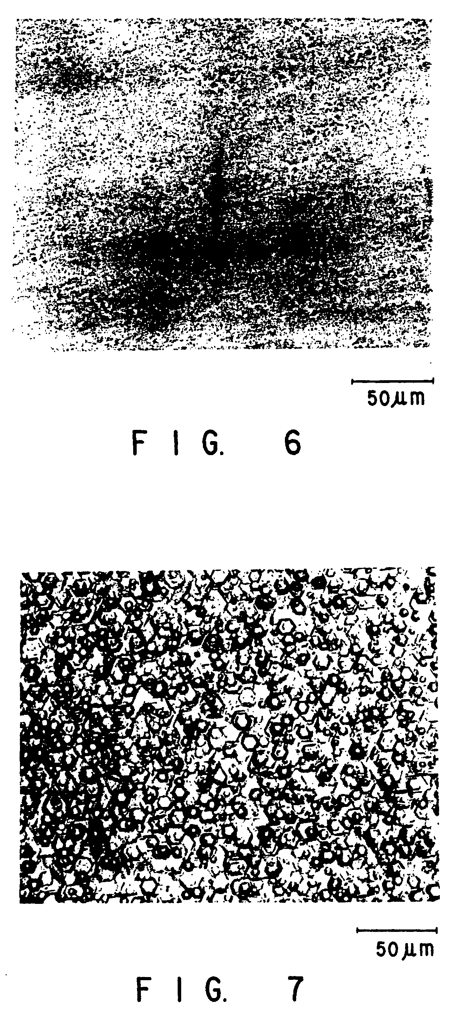

Figs. 4 to 7 are microphotographs showing the structures of the surfaces of GaN epitaxial layers obtained when GaN buffer layers having different film thicknesses were formed on sapphire substrates and 4-µm thick GaN epitaxial layer were grown on the respective buffer layers. The thicknesses of the buffer layers shown in Figs. 4 to 7 are 0.002 µm, 0.07 µm, 0.20 µm, and 0 µm (no buffer layer) in this order.

As can be seen from these drawings, hexagonal crystal pillars appear on the surface when no buffer layer is formed. Although it depends on the formation conditions of the buffer layer, the surface of the buffer layer tends to have a mirror surface uniformity as the formation of the buffer layer advances. However, when the buffer layer is too thick, the surface state (surface morphology) is deteriorated. A preferable thickness of the buffer layer is, therefore, 0.01 µm to 0.2 µm.

The temperature at which an epitaxial layer of the compound represented by the formula Ga_{X}Al_{1-X}N (0 ≦ X ≦ 1) are formed on the buffer layer is 900°C to 1150°C. If the temperature is less than 900°C, gallium nitride-based compound tends to become polycrystalline. If the temperature exceeds 1150°C, gallium nitride crystals tend to decompose during growing.

The buffer layer according to the crystal growth method of the present invention can be formed not only on a sapphire substrate but also on any layer as long as the layer has an epitaxial semiconductor layer of a compound represented by the formula Ga_{X}Al_{1-X}N (0 ≦ X ≦ 1). Thus, according to the present invention the gallium nitride-based compound semiconductor can form a multi layer structure such as buffer/epitaxial/buffer/epitaxial structure and buffer/epitaxial/epitaxial/buffer/epitaxial structure.

For example, when it is desired to form a p-type GaN epitaxial layer doped with Mg as a p-type impurity on an n-type GaN epitaxial layer, it is also possible to form a buffer layer on the n-type GaN epitaxial layer and to form the p-type GaN epitaxial layer on the buffer layer.

According to the present invention, the buffer layer and/or the epitaxial layer of the compound represented by the formula Ga_{X}Al_{1-X}N (0 ≦ X ≦ 1) formed on the buffer layer can be doped with an n- or p-type impurity.

More specifically, this growth method of the present invention is a method of supplying a reaction gas into a reactor to grow an epitaxial layer consisting of an n- or p-type gallium nitride compound. The characteristic feature of this method is that before the growth of the epitaxial layer, an n- or p-type impurity is doped in a buffer layer represented by the formula GaₓAℓ₁₋ₓN (0.5 ≦ X ≦ 1) to grow a polycrystalline layer at a first temperature of 400°C to 800°C, and then an n- or p-type impurity is doped in the surface of the buffer layer at a second temperature of 900°C to 1150°C or more to grow an epitaxial layer of a compound represented by the formula Ga_{X}Al_{1-X}N (0 ≦ X ≦ 1).

As the impurity to be doped in the compound represented by the formula Ga_{X}Al_{1-X}N (0 ≦ X ≦ 1) to impart n conductivity type to it, it is possible to use, for example, Si and Sn. Examples of the impurity for imparting p conductivity type to the compound represented by the formula Ga_{X}Al_{1-X}N (0 ≦ X ≦ 1) are Zn, Mg, Ca, and Be. In the growth method of the present invention, the impurity for imparting n or p conductivity type to the gallium nitride-based compound is not particularly limited. In the method of the present invention, it is possible to dope any impurity which is presently, already used or may be developed in the future in order to impart p or n conductivity type to the gallium nitride-based compound semiconductor.

The concentration of the impurity to be doped in the semiconductor crystal film is preferably as large as possible because the resistance of a semiconductor crystal film decreases when an impurity is heavily doped in it. A concentration at which the impurity can be doped without deteriorating the crystallinity of the epitaxial layer is preferably 10¹⁷ to 10²⁰ cm³.

The thickness of the buffer layer is 0.001 to 0.2 µm. If the thickness is less than 0.001 µm or more than 0.5 µm, the surface state and the crystallinity of the epitaxial layer of the n- or p-type gallium nitride-based compound formed on the surface of the buffer layer tend to deteriorate. For example, hexagonal crystal pillars appear on the surface of the semiconductor crystal film when no buffer layer is present. The crystal surface tends to have a mirror surface uniformity as the formation of a buffer layer proceeds though it depends on the formation conditions of the buffer layer. However, if the buffer layer is too thick, the surface state and the crystallinity of the semiconductor crystal film again tend to deteriorate.

According to the crystal growth method of the present invention, it is possible to form an epitaxial layer of a p-type compound represented by the formula Ga_{X}Al_{1-X}N (0 ≦ X ≦ 1) on the surface of a buffer layer doped with, e.g., a p-type impurity and to radiate an electron beam onto this epitaxial layer. The p-type gallium nitride-based compound semiconductor manufactured by this method has a large electron-beam radiating effect and can provide a particularly excellent p-type epitaxial layer as compared with a p-type epitaxial layer stacked on a buffer layer not doped with any p-type impurity.

According to the growth method of the present invention, a p-type GaN epitaxial layer can be grown through the following steps.

First, an Mg-doped polycrystalline buffer layer is grown at a low temperature of 400°C to 800°C. Subsequently, in order to grow an epitaxial layer of Mg-doped p-type GaN on the surface of the buffer layer, the temperature is raised to about 1,000° C. At this time, the buffer layer partially becomes monocrystalline to form a seed crystal for growing p-type GaN.

The manner of this conversion into single crystals will be described in more detail below. During the temperature rise to 1,000°C, Mg in the buffer layer causes rearrangement to a Ga lattice site to facilitate its entrance into the Ga site. Therefore, when the temperature is raised to 1,000°C and the Mg-doped p-type GaN epitaxial layer is grown, the buffer layer in which Mg enters the Ga site serves as a seed crystal to make it easier for Mg to enter a Ga site in the p-type GaN epitaxial layer to be grown on the surface of the buffer layer.

As described above, doping Mg in the buffer layer facilitates formation of an epitaxial layer of a p-type gallium nitride-based compound, which is difficult to perform in conventional methods.

The compound semiconductor epitaxial layer represented by the formula Ga_{X}Al_{1-X}N (0 ≦ X ≦ 1) has a property to acquire n conductivity type without being doped with an impurity such as Si. For this reason, it is not always necessary to dope Si in the semiconductor crystal film in order to impart n conductivity type to the gallium nitride-based compound semiconductor. However, when a gallium nitride-based compound semiconductor is grown on the surface of a buffer layer doped with an n-type impurity, an n-type epitaxial layer having more preferable characteristics can be formed.

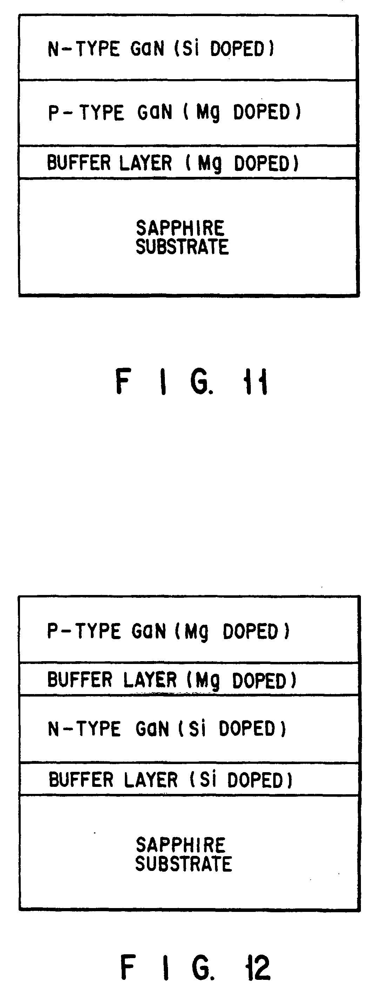

Figs. 11 and 12 are sectional views showing the structures of light-emitting diodes of an embodiment according to the present invention. As illustrated in the embodiment of Figs. 11 and 12, a buffer layer doped with an impurity may be formed not only on the sapphire substrate but also on any layer.

The reaction gas used in the present invention preferably contains at least one material selected from the group consisting of trimethylgallium, trimethylaluminum and triethyl aluminum. This reaction gas also preferably contains at least one material selected from the group consisting of ammonia gas and hydrazine. This reaction gas also more preferably contains at least one gas selected from the group consisting of trimethylindium, cyclopentadienyl-magnesium, diethyzinc, and trimethylzinc.

The substrate is selected from the group consisting of sapphire, Si, SiC, GaP, InP and GaAs.

Examples of the present invention will be described below. However, the following Examples merely exemplify the method of practicing the technical concept of the present invention. Therefore, the method of the present invention is not particularly limited to the Examples below in terms of, e.g., the growth conditions, the type of an organometallic compound gas, and the materials used. Various modifications can be made for the growth method of the present invention in accordance with the scope of claims.

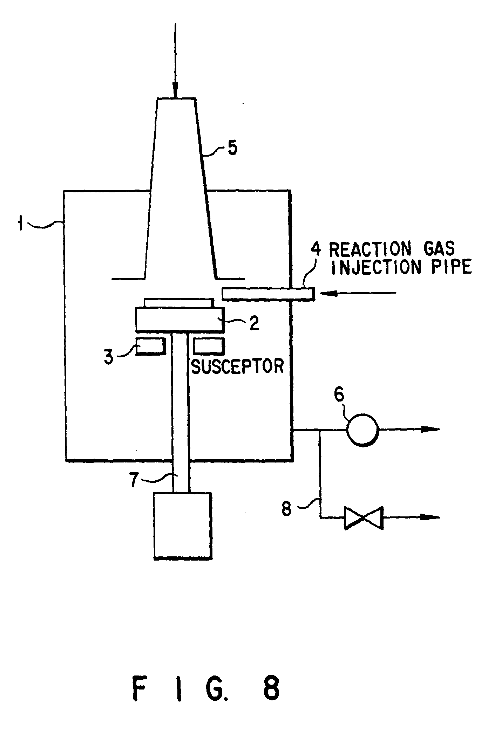

An apparatus shown in Fig. 8 was used to perform crystal growth of a gallium nitride-based compound semiconductor.

### Example 1

A GaN epitaxial layer was grown to have a film thickness of 4 µm on a sapphire substrate in accordance with the following steps.
(1) A washed sapphire substrate having a diameter of 2 inches was placed on a susceptor 2.
(2) The air in a stainless steel reactor 1 was sufficiently exhausted by an exhaust pump 6, and H₂ gas was introduced into the reactor 1, thus replacing the air in the reactor with H₂ gas.
(3) Thereafter, the susceptor 2 was heated up to 1,060 ° C by a heater 3 while supplying H₂ gas into the reactor 1 from a reaction gas injection pipe 4 and an injection subpipe 5 in the upper portion of the reactor 1.
(4) This state was held for 10 minutes to remove an oxide film from the surface of the sapphire substrate.
(5) The temperature of the susceptor 2 was then decreased to 500°C, and the substrate was left to stand until the temperature became stable.
(6) Subsequently, a gas mixture of H₂ and N₂ was supplied from the injection subpipe 5, and a gas mixture of ammonia gas and H₂ gas was supplied from the reaction gas injection pipe 4. The flow rate of each of the H₂ and N₂ gases supplied from the injection subpipe 5 was 10 ℓ/min, and the flow rates of the ammonia gas and the H₂ gas supplied from the reaction gas injection pipe 4 were 4 ℓ/min and 1 ℓ/min, respectively. This state was maintained until the temperature of the susceptor 2 was stabilized at 500°C.
(7) Thereafter, in order to form a buffer layer, TMG (trimethylgallium) gas was flowed at a flow rate of 2.7 x 10⁻⁵ mol/min for one minute in addition to the ammonia and H₂ gases from the reaction gas injection pipe 4.
(8) Subsequently, only the TMG gas was stopped to stop the growth of the buffer layer. The result was a 0.02-µm thick buffer layer. The temperature of the susceptor 2 was increased to 1,020 °C while flowing the other gases.
(9) After the temperature of the susceptor 2 was raised to 1,020°C, TMG gas was flowed at a flow rate of 5.4 x 10⁻⁵ mol/min for 60 minutes in addition to the ammonia and H₂ gases from the reaction gas injection pipe 4, thereby growing a GaN epitaxial layer to have a film thickness of 4.0 µm.

During the growth, the H₂ and N₂ gases were constantly supplied from the injection subpipe 5 under the conditions described above so that the interior of the reactor was not contaminated with the reaction gas. In addition, the susceptor 2 was rotated at a rate of 5 rpm by a motor 7 so as to uniformly grow crystals. Note that while the gases were supplied, the supplied gases were exhausted outside from an exhaust pipe 8 branched from piping of the exhaust pump 6.

In this manner, the 0.02-µm thick GaN buffer layer and the 4-µm thick GaN epitaxial layer were grown on the sapphire substrate.

### Control 1

A 4-µm thick GaN epitaxial layer was grown on an AℓN buffer layer following the same procedures as in Example 1 except that the AℓN buffer layer was formed to have a film thickness of 0.02 µm in the step (7) of forming the buffer layer.

In the formation of the AℓN buffer layer, TMA (trimethylaluminum) was flowed at a flow rate of 2.7 x 10⁻⁵ mol/min in addition to ammonia and H₂ gases from the reaction gas injection pipe 4 in the step (7).

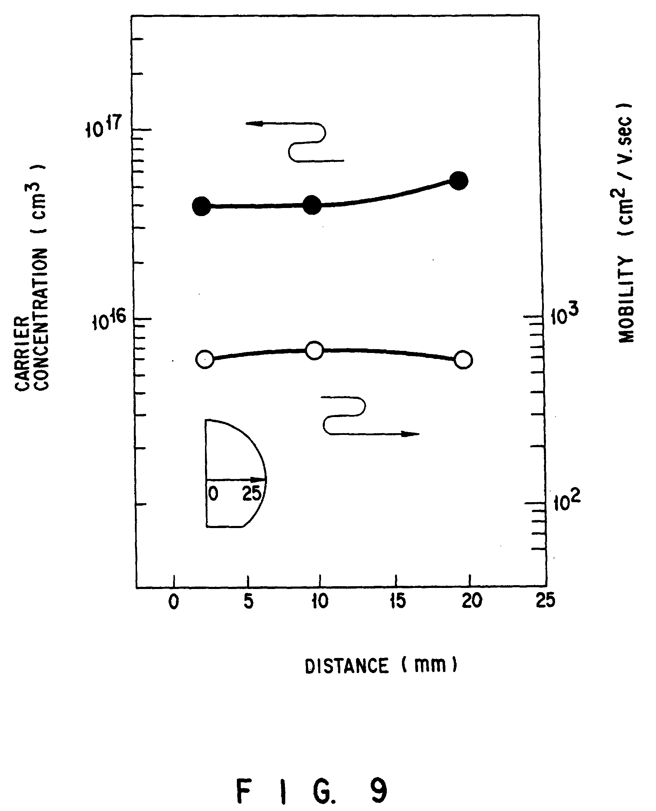

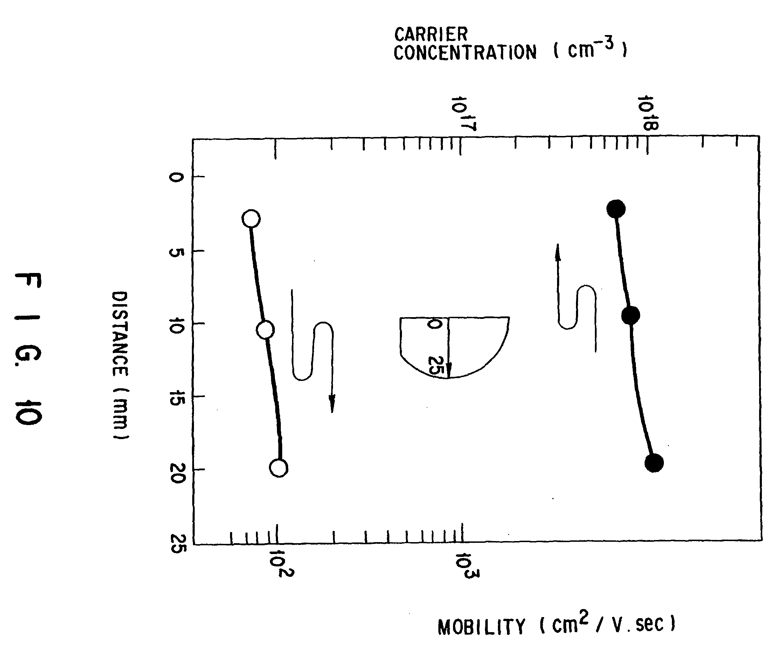

After the growth, a Hall measurement was performed at room temperature to obtain the carrier concentration and the mobility of the GaN epitaxial layer according to the present invention and those of the GaN epitaxial layer of Control 1. Each of Figs. 9 and 10 shows the two-dimensional distributions of the carrier concentration and the mobility. The results of the present invention are shown in Fig. 9, and those of the control are shown in Fig. 10, in which the carrier concentration is represented by o, and the mobility is represented by o.

Referring to Figs. 9 and 10, in the case of growth of nondoped crystals, as the carrier concentration decreases and the mobility increases, the crystallinity is improved and the impurity concentration is decreased.

As is apparent from Fig. 9, the GaN according to the present invention exhibits very good values: a carrier concentration of 4 x 10¹⁶/cm³ and a mobility of about 600 cm²/V•sec.

As is apparent from Fig. 10, GaN of Comparative Example 1 using AℓN as the buffer layer exhibited a carrier concentration of 1 x 10¹⁸/cm³ and a mobility of bout 90 cm²/V•sec.

### Example 2

A GaN epitaxial layer was grown on a Ga_{0.5}Aℓ_{0.5}N buffer layer following the same procedures as in Example 1 except that the buffer layer was formed to have a film thickness of 0.02 µm in the step (7) of forming the buffer layer.

In the formation of the buffer layer, TMG and TMA were flowed at flow rates of 2.7 × 10⁻⁵ mol/min and 2.7 x 10⁻⁵ mol/min, respectively, for 0.5 minutes each in addition to ammonia and H₂ gases from the reaction gas injection pipe 4.

As shown in Fig. 3, this GaN epitaxial layer also had an excellent X-ray rocking curve. In addition, the surface morphology of the layer obtained by microscopic observation was equivalent to that of Example 1, and its carrier concentration and mobility were intermediate between those of Example 1 and Control 1.

### Example 3

A gallium nitride epitaxial layer was grown following the same procedures as in Example 1 except that the growth temperature of a buffer layer was set at 600°C in the step (6) and the gas flow time was changed to 2.5 minutes in the step (7) so that the buffer layer was formed to have a film thickness of 0.05 µm.

The surface morphology of this gallium nitride epitaxial layer was equivalent to that of Example 1, and the full-width at half maximum of its X-ray rocking curve was three minutes, indicating good crystallinity. In addition, both of the carrier concentration and the mobility of the layer were equivalent to those of Example 1.

### Example 4

A gallium nitride epitaxial layer was grown following the same procedures as in Example 1 except that the growth temperature of a buffer layer was set at 800 °C in the step (6).

The surface morphology of this GaN epitaxial layer was equivalent to that of Example 1, and the full-width at half maximum of its X-ray rocking curve was three minutes, indicating good crystallinity. In addition, both of the carrier concentration and the mobility of the layer were equivalent to those of Example 1.

### Example 5

A 0.02-µm thick Ga_{0.5}Aℓ_{0.5}N buffer layer was formed on a sapphire substrate according to Example 2 and a 4-µm thick Ga_{0.5}Aℓ_{0.5}N epitaxial layer was grown on the buffer layer following the same procedures as in Example 1 except that in the step (9), TMA gas and TMG gas were supplied at flow rates of 2.7 x 10⁻⁵ mol/min and 2.7 × 10⁻⁵ mol/min, respectively, for 60 minutes in addition to ammonia and H₂ gases from the reaction gas injection pipe 4.

The surface morphology of this 4-µm thick Ga_{0.5}Aℓ_{0.5}N epitaxial layer was equivalent to that of Example 1.

### Example 6

In the step (9), Mg as a p-type impurity was doped in a GaN epitaxial layer while Cp₂Mg (biscyclopentadienylmagnesium) gas was flowed in addition to ammonia gas, H₂ gas, and TMG gas, thereby growing a p-type GaN epitaxial layer to have a film thickness of 4.0 µm.

In the manner described above, a 0.02-µm thick GaN buffer layer was formed on a sapphire substrate, and the 4.0-µm thick p-type GaN epitaxial layer doped with 10²⁰/cm³ of Mg was grown on the buffer layer.

This p-type GaN epitaxial layer also had a surface morphology equivalent to that of Example 1. In addition, the layer had a hole carrier concentration of 2.0 x 10¹⁵/cm³ and a mobility of 9.4 cm²/V•sec, i.e., exhibited p-type characteristics for the first time as a gallium nitride-based compound semiconductor. This indicates that the crystallinity of this epitaxial film is very good.

### Example 7

Following the same procedures as in Example 6, a 0.02-µm thick GaN buffer layer was formed on the 4-µm thick GaN epitaxial layer obtained by the same procedure as in Example 1, and a 4.0-µm thick p-type GaN epitaxial layer doped with 10²⁰/cm³ of Mg was grown on the buffer layer.

This p-type epitaxial layer also had a surface morphology equivalent to that in Example 1 and had a carrier concentration of 3.5 x 10¹⁵/cm³ and a mobility of 8.5 cm²/V•sec, i.e., similarly exhibited p-type characteristics.

### Example 8

In the step (9), Si as an n-type impurity was doped in a GaN epitaxial layer while silane (SiH₄) gas was flowed in addition to ammonia gas, H₂ gas, and TMG gas, thereby growing the layer to have a film thickness of 4.0 µm.

In the manner described above, a 0.02-µm thick GaN buffer layer was formed on a sapphire substrate, and the 4-µm thick n-type GaN epitaxial layer doped with about 10²⁰/cm³ of Si was grown on the buffer layer.

This n-type GaN epitaxial layer also had a surface morphology equivalent to that in Example 1 and exhibited a very high carrier concentration of 1.0 x 10¹⁹/cm³.

### Control 2

An AℓN buffer layer was formed on a sapphire substrate by doping Si following the same procedures as in Example 8 except that the buffer layer was formed to have a film thickness of 0.02 µm, and a 4-µm thick n-type GaN epitaxial layer was formed on the buffer layer.

The carrier concentration of this n-type GaN epitaxial layer was 5.0 x 10¹⁸/cm³, i.e., low compared to Control 1. It is assumed that this low carrier concentration was caused by compensation by the impurity.

### Example 9

In the step (7), in order to form a buffer layer, TMG (trimethylgallium) gas and Cp₂Mg (biscyclopentadienylmagnesium) gas were flowed in addition to ammonia gas and H₂ gas from the reaction gas injection pipe 4, thereby forming a 0.04-µm thick buffer layer.

In the step (9), after the temperature of the susceptor rose to 1,000 °C, TMG gas and Cp₂Mg gas were supplied in addition to the ammonia and H₂ gases from the reaction gas injection pipe 4, thereby growing a p-type GaN epitaxial layer to have a film thickness of 4.0 µm.

In the manner described above, the 0.04-µm thick GaN buffer layer doped with Mg as a p-type impurity was formed on a sapphire substrate, and the 4-µm thick p-type GaN epitaxial layer doped with Mg was grown on the buffer layer. Note that the doping amount of Mg was 10²⁰/cm³ in both the buffer and p-type epitaxial layers.

Thereafter, a Hall measurement was performed for this p-type GaN epitaxial layer. The results were a carrier concentration of 4.5 x 10¹⁷/cm³, a resistivity of 1.0 Ω·cm, and a Hall mobility of 9.0 cm²/V•sec.

### Example 10

An electron beam irradiation treatment was performed under the condition that acceleration voltage was maintained at 5 kV on the entire surface of the p-type GaN epitaxial layer obtained in Example 9, thus further imparting p conductivity type to a layer with a thickness of about 0.2 µm from the surface.

The obtained p-type GaN epitaxial layer was subjected to a Hall measurement. As a result, in the layer 0.2 µm thick from the surface, the carrier concentration, the resistivity, and the Hall mobility were improved to 4.6 x 10¹⁸/cm³, 0.3 Ω•cm, and 11.0 cm²/V•sec, respectively.

### Control 3

A buffer layer and a p-type GaN epitaxial layer doped with 10²⁰/cm³ of Mg were grown to have thicknesses of 0.04 µm and 4 µm, respectively, following the same procedures as in Example 9 except that no Mg was doped in the buffer layer. Thereafter, following the same procedures as in Example 10, an electron beam radiation was performed to further impart p conductivity type to a layer with a thickness of about 0.2 µm from the surface.

The results of Hall measurement were a carrier concentration of 3 x 10¹⁷/cm³, a resistivity of 2 Ω•cm, and a Hall mobility of 10 cm²/V•sec in the layer 0.2 µm thick from the surface.

As described above, forming Ga_{X}Aℓ_{1-X}N (0.5 ≦ X ≦ 1) as a buffer layer drastically improves the crystallinity of an epitaxial layer of a compound represented by the formula Ga_{X}Al_{1-X}N (0 ≦ X ≦ 1) grown on the buffer layer. For example, in a Hall measurement of crystals, a mobility of 600 cm²/V·sec is the most excellent value of the epitaxial layer.

In addition, since the buffer layer is formed, the Mg-doped GaN epitaxial layer grown on the buffer layer exhibits p conductivity type without performing any treatment. This is the phenomenon never encountered in conventional techniques, which indicates that the crystallinity of the epitaxial layer of the gallium nitride-based compound semiconductor grown by the method of the present invention is very excellent. Also, Si-doped n-type GaN grown on the buffer layer has a carrier concentration much higher than that of GaN using AℓN as a buffer layer.

Furthermore, the conditions under which the buffer layer of the present invention is to be grown are less severe than those for a conventional AℓN buffer layer. That is, the crystallinity of an epitaxial layer of the compound represented by the formula Ga_{X}Al_{1-X}N (0 ≦ X ≦ 1) grown on a buffer layer is good over a wide range of buffer layer thickness. This results in a high productivity in the manufacture of light-emitting devices.

In addition, since doping an n- or p-type impurity in a buffer layer grown at a low temperature improves the conductivity characteristics of a semiconductor epitaxial layer of the n- or p-type compound represented by the formula Ga_{X}Al_{1-X}N (0 ≦ X ≦ 1) to be subsequently grown on the buffer layer, a p-n junction can be easily formed. Table 1 below indicates how good the characteristics of the p-type epitaxial layer of the gallium nitride-based compound are.

**Table 1**

| | Hole Carrier Concentration number/cm³ | Resistivity (Ω•cm) | Hall mobility cm³/V•sec |
|---|---|---|---|
| Example 9 | 4.5 × 10¹⁷ | 1.0 | 9.0 |
| Example 10 | 4.6 x 10¹⁸ | 0.2 | 11.0 |
| Comparative Example 3 | 3 x 10¹⁷ | 2 | 10.0 |

As shown in Table 1, in the case of a p-type GaN epitaxial layer, the carrier concentration and the resistivity of the layer respectively reach practical levels to improve the performance of the layer to be 100 times or more that of the conventional example. Especially when an electron beam is radiated onto a p-type GaN epitaxial layer grown by the crystal growth method of the present invention, the carrier concentration of the layer is improved to be nearly 1,000 times.

As has been described above, the use of the technique of the present invention makes it possible to utilize crystals of an epitaxial layer of a compound represented by the formula GaₓAl₁₋ₓN (0 ≦ X ≦ 1) over a wide range of applications from a blue light-emitting diode to a semiconductor laser at practical levels.

## Claims

1. A crystal growth method for a gallium nitride compound semiconductor, comprising the steps of:
vapor-growing a polycrystalline buffer layer represented by formula GaₓAl₁₋ₓN (0.5 ≤ x ≤ 1), having a thickness of 0.001 to 0.2 µm, on a substrate by metal organic chemical vapor deposition at a first temperature in the range of 400 to 800°C; and
vapor-growing an epitaxial semiconductor layer represented by formula GaₓAl₁₋ₓN (0 ≤ x < 1) on said formed buffer layer by metal organic chemical vapor deposition at a second temperature in the range of 900°C to 1150°C.

2. A method according to claim 1 **characterized by** further comprising the steps of:
vapor-growing another polycrystalline buffer layer represented by formula GaₓAl₁₋ₓN (0.5 < x < 1), having a thickness of 0.001 to 0.2 µm, on said gallium nitride-based compound semiconductor layer by metal organic chemical vapor deposition at a third temperature lower than said second temperature; and
vapor-growing an epitaxial semiconductor layer represented by formula GaₓAl₁₋ₓN (0 ≤ x ≤ 1) on said another buffer layer by metal organic chemical vapor deposition at a fourth temperature higher than said third temperature.

3. A method according to claim 1, **characterized by** further comprising the step of doping an n- or p-type impurity in said buffer layer.

4. A method according to claim 3, **characterized in that** said n-type impurity is at least one material selected from the group consisting of Si and Sn.

5. A method according to claim 3, **characterized in that** said p-type impurity is at least one material selected from the group consisting of Zn, Mg, Ca, and Be.

6. A method according to claim 3, **characterized in that** the doping amount of said n- or p-type impurity is -10¹⁷ to 10²⁰/cm³.

7. A method according to claim 1, **characterized by** further comprising the step of doping an n- or p-type impurity in said semiconductor layer.

8. A method according to claim 7, **characterized in that** said n-type impurity is at least one material selected from the group consisting of Si and Sn.

9. A method according to claim 7, **characterized in that** said p-type impurity is at least one material selected from the group consisting of Zn, Mg, Ca, and Be.

10. A method according to claim 7, **characterized in that** the doping amount of said n- or p-type impurity is 10¹⁷ to 10²⁰/cm³.

11. A method according to claim 1, **characterized in that** said buffer layer is grown by using a reaction gas containing at least one gas selected from the group consisting of trimethyl gallium and triethylgallium, and at least one gas selected from the group consisting of ammonia gas and hydrazine.

12. A method according to claim 11, **characterized in that** said reaction gas contains trimethylaluminum.

13. A method according to claim 11, **characterized in that** said reaction gas contains at least one gas selected from the group consisting of cyclopentadienylmagnesium, diethylzinc, and trimethylzinc.

14. A method according to claim 1, **characterized in that** said substrate comprises one material selected from the group consisting of sapphire, Si, SiC and GaAs.

15. A method according to claim 12, **characterized by** further comprising, after the formation of said semiconductor layer, the step of radiating an electron beam onto the formed semiconductor layer.

16. A method according to claim 1, **characterized in that** said semiconductor layer has the same composition of said buffer layer and is represented by formula Ga_{X}Aℓ_{1-X}N (0.5 ≦ X ≦ 1).

## Patentansprüche

1. Verfahren zum Aufwachsen eines Verbindungshalbleiters auf Galliumnitrid-Basis, mit den Verfahrensschritten:
Aufwachsen einer polykristallinen Pufferschicht, dargestellt durch die Formel GaₓAl₁₋ₓN (0.5 ≤ x ≤ 1), aus der Gasphase mit einer Dicke im Bereich von 0.001 bis 0.2 um auf einem Substrat bei einer ersten Temperatur im Bereich von 400 bis 800°C durch metall-organische chemische Dampfabscheidung; und
Aufwachsen einer epitaktischen Halbleiterschicht, dargestellt durch die Formel GaₓAl₁-ₓN (0 ≤ x < 1), aus der Gasphase auf der gebildeten Pufferschicht bei einer zweiten Temperatur im Bereich von 900°C bis 1150°C durch metall-organische chemische Dampfabscheidung.

2. Verfahren gemäß Anspruch 1, **gekennzeichnet durch** die weiteren Verfahrensschritte:
Aufwachsen einer weiteren polykristallinen Pufferschicht, dargestellt **durch** die Formel GaₓAl₁-ₓN (0 ≤ x ≤ 1), aus der Gasphase mit einer Dicke im Bereich von 0.001 bis 0.2 µm auf der Galliumnitrid-basierten Verbindungshalbleiterschicht bei einer dritten Temperatur, die geringer als die zweite Temperatur ist, **durch** metall-organische chemische Dampfabscheidung; und
Aufwachsen einer epitaktischen Halbleiterschicht, dargestellt **durch** die Formel GaₓAl₁₋ₓN (0 ≤ x ≤ 1), aus der Gasphase auf der gebildeten Pufferschicht bei einer vierten Temperatur, die höher als die dritte Temperatur ist, **durch** metall-organische chemische Dampfabscheidung.

3. Verfahren nach Anspruch 1, **gekennzeichnet durch** den weiteren Verfahrensschritt der Dotierung der Pufferschicht **durch** Verunreinigungen vom n- oder p-Typ.

4. Verfahren nach Anspruch 3, **dadurch gekennzeichnet, dass** die Verunreinigung vom n-Typ mindestens ein aus der aus Si und Sn bestehenden Gruppe ausgewähltes Material ist.

5. Verfahren nach Anspruch 3, **dadurch gekennzeichnet, dass** die Verunreinigung vom p-Typ mindestens ein aus der aus Zn, Mg, Ca, und Be bestehenden Gruppe ausgewähltes Material ist.

6. Verfahren nach Anspruch 3, **dadurch gekennzeichnet, dass** der Dotierungsgrad an Verunreinigungen des n- oder p-Typs 10¹⁷ bis 10²⁰/cm³ ist.

7. Verfahren nach Anspruch 1, **gekennzeichnet durch** den weiteren Verfahrensschritt der Dotierung der Halbleiterschicht mit Verunreinigungen vom n- oder p-Typ.

8. Verfahren nach Anspruch 7, **dadurch gekennzeichnet, dass** die Verunreinigung vom n-Typ mindestens ein aus der aus Si und Sn bestehenden Gruppe ausgewähltes Material ist.

9. Verfahren nach Anspruch 7, **dadurch gekennzeichnet, dass** die Verunreinigung vom p-Typ mindestens ein aus der aus Zn, Mg, Ca, und Be bestehenden Gruppe ausgewähltes Material ist.

10. Verfahren nach Anspruch 7, **dadurch gekennzeichnet, dass** der Dotierungsgrad an Verunreinigungen des n- oder p-Typs 10¹⁷ bis 10²⁰/cm³ ist.

11. Verfahren nach Anspruch 1, **dadurch gekennzeichnet, dass** die Pufferschicht unter Verwendung eines Reaktionsgases aufgewachsen wird, das mindestens ein Gas enthält, das ausgewählt ist aus der Gruppe bestehend aus Trimethylgallium und Triethylgallium, und mindestens einem Gas, das ausgewählt ist aus der Gruppe bestehend aus Ammoniakgas und Hydrazin.

12. Verfahren nach Anspruch 11, **dadurch gekennzeichnet, dass** das Reaktionsgas Trimethylaluminium enthält.

13. Verfahren nach Anspruch 11, **dadurch gekennzeichnet, dass** das Reaktionsgas mindestens ein Gas enthält, das aus der Gruppe bestehend aus Cyclopentadienylmagnesium, Diethylzink und Trimethylzink ausgewählt ist.

14. Verfahren nach Anspruch 1, **dadurch gekennzeichnet, dass** das Substrat ein Material aufweist, das aus der Gruppe bestehend aus Saphir, Si, SiC und GaAs ausgewählt ist.

15. Verfahren nach Anspruch 12, **gekennzeichnet durch** den weiteren Verfahrensschritt, dass nach der Bildung der Halbleiterschicht die gebildete Halbleiterschicht mit einem Elektronenstrahl bestrahlt wird.

16. Verfahren nach Anspruch 1, **dadurch gekennzeichnet, dass** die Halbleiterschicht die gleiche Zusammensetzung wie die Pufferschicht aufweist und durch die Formel GaₓAl₁₋ₓN (0.5 ≤ x ≤ 1) dargestellt ist.

## Revendications

1. Procédé de croissance cristalline d'un composé semiconducteur à base de nitrure de gallium, comprenant les étapes consistant
- à déposer sur un substrat, par dépôt chimique en phase vapeur d'un composé organométallique à une première température comprise entre 400 et 800 °C, une couche tampon polycristalline représentée par la formule GaₓAl₁₋ₓN (0,5 ≤ x ≤ 1) et ayant une épaisseur comprise dans l'intervalle allant de 0,001 à 0,2 µm, et
- à déposer, sur ladite couche tampon formée, par dépôt chimique en phase vapeur d'un composé organométallique à une deuxième température comprise dans l'intervalle allant de 900 à 1150 °C, une couche de semiconducteur epitaxiale représentée par la formule GaₓAl₁₋ₓN (0 ≤ x ≤ 1).

2. Procédé conforme à la revendication 1, **caractérisé en ce qu'**il comprend en outre les étapes consistant :
- à déposer, sur ladite couche de composé semi-conducteur à base de nitrure de gallium, par dépôt chimique en phase vapeur d'un composé organique à une troisième température inférieure à la seconde température, une autre couche tampon polycristalline représentée par la formule GaₓAl₁₋ₓN (0,5 ≤ x ≤ 1) et ayant une épaisseur comprise dans l'intervalle allant de 0,001 à 0,2 µm, et
- à déposer, sur ladite autre couche tampon formée, par dépôt chimique en phase vapeur d'un composé organométallique à une quatrième température supérieure à la troisième température, une couche de semiconducteur epitaxiale représentée par la formule GaₓAl₁₋ₓN (0 ≤ x ≤ 1).

3. Procédé conforme à la revendication 1, **caractérisé en ce qu'**il comprend en outre l'étape consistant à doper ladite couche tampon avec une impureté de type n ou p.

4. Procédé conforme à la revendication 3, **caractérisé en ce que** ladite impureté de type n est au moins une substance choisie dans le groupe formé par Si et Sn.

5. Procédé conforme à la revendication 3, **caractérisé en ce que** ladite impureté de type p est au moins une substance choisie dans le groupe formé par Zn, Mg, Ca et Be.

6. Procédé conforme à la revendication 3, **caractérisé en ce que** la quantité dopante de ladite impureté de type n ou p est comprise dans l'intervalle allant de 10¹⁷ à 10²⁰/cm³.

7. Procédé conforme à la revendication 1, **caractérisé en ce qu'**il comprend en outre l'étape consistant à doper ladite couche de semiconducteur avec une impureté de type n ou p.

8. Procédé conforme à la revendication 7, **caractérisé en ce que** ladite impureté de type n est au moins une substance choisie dans le groupe formé par Si et Sn.

9. Procédé conforme à la revendication 7, **caractérisé en ce que** ladite impureté de type p est au moins une substance choisie dans le groupe formé par Zn, Mg, Ca et Be.

10. Procédé conforme à la revendication 7, **caractérisé en ce que** la quantité dopante de ladite impureté de type n ou p est comprise dans l'intervalle allant de 10¹⁷ à 10²⁰/cm³.

11. Procédé conforme à la revendication 1, **caractérisé en ce que** l'on dépose ladite couche tampon en utilisant un gaz réactif contenant au moins un gaz choisi dans le groupe formé par le triméthyl-gallium et le triéthylgallium, et au moins un gaz choisi dans le groupe formé par l'ammoniac gazeux et l'hydrazine.

12. Procédé conforme à la revendication 11, **caractérisé en ce que** ledit gaz réactif contient du triméthyl-aluminium.

13. Procédé conforme à la revendication 11, **caractérisé en ce que** ledit gaz réactif contient au moins un gaz choisi dans le groupe formé par le cyclopentadiényl-magnésium, le diéthyl-zinc et le triméthyl-zinc.

14. Procédé conforme à la revendication 1, **caractérisé en ce que** ledit substrat est composé d'un matériau choisi dans le groupe formé par du saphire, du Si, du SiC et du GaAs.

15. Procédé conforme à la revendication 12, **caractérisé en ce qu'**il comprend en outre, après la formation de ladite couche de semi-conducteur, l'étape consistant à irradier la couche de semiconducteur formée par un rayonnement d'électrons.

16. Procédé conforme à la revendication 1, **caractérisé en ce que** ladite couche de semiconducteur a la même composition que ladite couche tampon, et est représentée par la formule GaₓAl₁₋ₓN (0,5 ≤ x ≤ 1).
